# EUROPÄISCHE PATENTANMELDUNG

(11) **EP 0 817 116 A2**
(43) Veröffentlichungstag der Anmeldung: **07.01.1998**
(21) Anmeldenummer: 97111181.0
(22) Anmeldetag: 03.07.1997
(51) Int. Cl.: G06K 19/077

(54) **Chipkarte sowie Verfahren und Herstellung einer Chipkarte**

(30) Priorität: 03.07.1996 DE 19626791
(71) Anmelder: ODS R. Oldenbourg Datensysteme GmbH & Co. KG, 85375 Neufahrn (DE)
(72) Erfinder: Schmidt, Frank, Dr., 99891 Fischbach (DE)
(74) Vertreter: Grünecker, Kinkeldey, Stockmair & Schwanhäusser Anwaltssozietät

(57) **Zusammenfassung**

Chipkarte, bestehend aus einem standardisierten Kartenkörper mit einem standardisierten Durchbruch zur Aufnahme eines einen Chip enthaltenden sowie entsprechende von außen zugängliche Anschlußfelder tragenden gegossenen Moduls, wobei das Modul ebenfalls derart standardisiert gefertigt ist, daß es paßgenau in den Durchbruch des Kartenkörpers einsetzbar ist und seine beiden parallelen Oberflächen jeweils mit der Vorder- und Rückseite des Kartenkörpers fluchten.

## Beschreibung

Die vorliegende Erfindung betrifft eine Chipkarte sowie ein spezielles Verfahren zum Herstellen einer derartigen Chipkarte.

Die vorliegende Erfindung geht aus von einer Problemstellung, wie sie bereits in der DE 43 44 297 A1 angesprochen ist.

Chipkarten werden für unterschiedliche Anwendungen mit sich in Größe und Funktion unterscheidenden Chips versehen. Bei einem Großteil der heute erhältlichen Chipkarten wird die sogenannte "Montagetechnik" angewandt, bei der ein Kartenkörper mit einer Aussparung gefertigt wird, in die anschließend ein im wesentlichen aus Trägerelement und Chip bestehendes Chipmodul eingesetzt wird, wobei die Verbindung zwischen Chipmodul und Kartenkörper üblicherweise mittels einer Klebeschicht erreicht wird.

Da sich, wie oben ausgeführt, die mittels der Chipmodule in die Kartenkörper einzusetzenden Chips in ihrer Größe unterscheiden, unterscheiden sich entsprechend auch die Größen der Chipmodule sowie in entsprechender Weise die Aussparungen in den Kartenkörpern.

Entsprechend der Größe des für eine spezielle Anwendung benötigten Chips muß somit zunächst ein geeignetes Chipmodul geschaffen werden, an das dann die Aussparung des den Chipmodul aufnehmenden Kartenkörpers angepaßt werden muß.

In fertigungstechnischer Hinsicht, insbesondere unter Berücksichtigung des ständigen Preisverfalls bei der Chipkartenherstellung, ist eine derartige Typenvielfalt nachteilig. Insbesondere unter Berücksichtigung, daß Chipmodule einerseits und Kartenkörper andererseits von unterschiedlichen Betrieben gefertigt werden, ist diese Situation darüber hinaus aus Lagerhaltungsgesichtspunkten unvorteilhaft.

In der Druckschrift DE 43 44 297 A1 wird es daher als wünschenswert angesehen, eine Möglichkeit zu schaffen, bei der gewährleistet ist, daß die Kartenkörper eine einheitliche Aussparung aufweisen und dennoch mit Chipmodulen unterschiedlicher Größe kombiniert werden können. Um dieses Ziel zu erreichen, wird in der DE 43 44 297 A1 vorgeschlagen, sogenannte Adapterelemente vorzusehen, die in ihren Außenabmessungen auf die einheitlichen Kartenkörperaussparungen zugeschnitten sind und einen Aufnahmebereich aufweisen, der in seiner Größe auf das gewünschte Chipmodul zugeschnitten ist. Für den Betrieb, der den Einbau der Chipmodule in die Kartenkörper vornimmt, ergibt sich dadurch der Vorteil, stets einheitliche Kartengrundkörper verwenden zu können und die Anpassung an Chipmodule mit unterschiedlichen Größen, mit entsprechend ausgelegten Adapterelementen vornehmen zu können.

Diese Lösungsmöglichkeit weist jedoch den Nachteil auf, daß nun statt unterschiedlicher Kartenkörper unterschiedliche Adapterelemente entsprechend den vorgesehenen unterschiedlichen Chipmodulen verfügbar und somit gelagert sein müssen. Zusätzlich wird hierdurch die Montage der Chipmodule in die Kartenkörper aufgrund der notwendigen zusätzlichen Einbringung eines Adapterelements verkompliziert.

Der vorliegenden Erfindung liegt die Aufgabe zugrunde, eine Lösungsmöglichkeit anzugeben, durch die die angesprochenen Nachteile beseitigt werden.

Diese Aufgabe wird durch den Gegenstand der Ansprüche 1, 11 und 12 gelöst.

Bevorzugte Ausführungsformen der vorliegenden Erfindung sind Gegenstand der Unteransprüche.

Der vorliegenden Erfindung liegt die Erkenntnis zugrunde, daß eine Lösung des angesprochenen Problems nur dadurch zu erzielen ist, daß neben den Kartenkörpern mit standardisierter Aussparung auch Chipmodule mit darauf zugeschnittenen standardisierten Außenabmessungen verwendet werden. Damit auch für zukünftige Anwendungen sehr große Chips verwendet werden können, wird erfindungsgemäß vorgeschlagen, ein standardisiertes Chipmodul zu verwenden, das eine Dicke aufweist, die der des Kartenkörpers entspricht. Erfindungsgemäß wird das standardisierte Chipmodul daher in einen Durchbruch des Kartenkörpers eingesetzt, so daß die beiden Hauptoberflächen des Chipmoduls mit den beiden Oberflächen des Kartenkörpers fluchten. Das Chipmodul selbst besteht dabei aus einem stabilen Spritz- oder Gußkörper, in dem der Chip eingebettet ist und der an seiner Oberfläche von außen zugängliche Kontaktfelder aufweist, die auch nach den Einsetzen des Chipmoduls in den Durchbruch des Kartenkörpers weiterhin zugänglich bleiben.

Die erfindungsgemäßen Merkmale unterscheiden die Chipkarte somit nicht nur vom Zweck her, sondern auch in ihrem Aufbau von den bereits bekannten "Minichipkarten". Minichipkarten weisen Kartenkörper auf, die wesentlich geringere Abmessungen zeigen als die üblicherweise verwendeten Normkarten. Minichipkarten werden beispielsweise für sehr kompakte Mobiltelefone verwendet. Damit der auf einer Minichipkarte vorhandene Chip auch in Zusammenhang mit Geräten verwendet werden kann, die zur Aufnahme von Normkarten ausgelegt sind, ist es heute bereits üblich, Minichipkarten zusammen mit Normkarten anzubieten, die einen Durchbruch aufweisen, in den die Minichipkarte eingesetzt werden kann, wenn sie in Zusammenhang mit Geräten verwendet werden soll, die nur zur Aufnahme von Normkarten geeignet sind.

Gemäß der vorliegenden Erfindung werden jedoch Chipmodule, die selbst keinen Kartenkörper aufweisen, in einen Kartenkörper eingesetzt. Zwar läßt es die erfindungsgemäße Lösung prinzipiell zu, daß der Anwender entsprechend unterschiedlicher Bedürfnisse den in den Kartenkörper eingesetzten Chipmodul durch einen anderen ersetzt, jedoch ist die Erfindung insbesondere darauf gerichtet, den Herstellungsprozeß bei den die Endkarten herstellenden Betrieben dadurch zu vereinfachen, daß mit einheitlichen Maschinen gearbeitet werden kann, durch die einheitliche Kartenkörper mit einheitlichen Chipmodulen zusammengesetzt werden. Das Ziel der vorliegenden Erfindung ist es somit nicht vordergründig, "Wechselmodulkarten" zur Verfügung zu stellen, sondern herkömmliche Chipkarten, die mit einem vereinfachten Herstellungsprozeß gefertigt werden können. Entscheidend ist, daß das nach bisherigen Techniken "sperrige" Modul, bestehend aus Trägerelement, Chip und Gußkörper, welcher den Chip schützt, nun als kompakte und paßgenau in den Kartenkörper einsetzbare Einheit gefertigt wird. Das gleiche Material, das bisher nur zum Schützen des Chips verwendet wurde, kann gemäß der Erfindung dazu verwendet werden, das Modul als geschlossene Einheit zu schaffen, die eine standardisierte Außenform aufweist, die paßgenau in einen Durchbruch oder in eine Aussparung im Kartenkörper eingesetzt werden kann.

Die vorliegende Erfindung unterscheidet sich somit grundlegend von den im Stand der Technik bereits bekannten Vorschlägen zum Befestigen sog. Minichipkarten in Standardkartenkörpern. Ein derartiger Vorschlag ist beispielsweise in der DE-U-29503249 enthalten, wobei hier insbesondere vorgeschlagen wurde, eine Minichipkarte in einen Standardkartenkörper einzuschieben. Bei dieser Lösung handelt es sich jedoch gerade nicht um das Einschieben eines Chipmoduls in den Standardkartenkörper sondern um das Einschieben einer funktionell fertigen Einheit, nämlich der Minichipkarte in einen Adapter, um die Minichipkarte auch für Anwendungen geeignet zu machen, die einen Standardkartenkörper erfordern. Insbesondere besteht der grundlegende Unterschied zur vorliegenden Erfindung darin, daß die vorgeschlagene Minichipkarte vorzugsweise aus einem Material gefertigt ist, das dem des eigentlichen Kartenkörpers entspricht, und daß hierzu nicht das Material verwendet wird, das für die Verkappung der integrierten Schaltung verwendet wird, wodurch in erfindungsgemäßer Weise eine Vereinfachung des Herstellungsprozesses erreicht wird, da der Schritt des Verkappens so ausgeführt wird, daß ein Chipmodul entsteht, das sich paßgenau in einen Durchbruch des Kartenkörpers einsetzen läßt. Folglich dient die in der DE-U-29503249 vorgeschlagene Lösung nicht zur Lösung des vorliegenden erfindungsgemäßen Problems. Vielmehr ermöglicht die dort vorgeschlagene Lösung die Verwendung einer als Adapter fungierenden Standardchipkarte für unterschiedliche Minichipkarten, die jeweils eine unterschiedliche Funktionalität aufweisen. Ähnlicher Stand der Technik, der sich auf Minichipkarten bezieht, wenngleich häufig eine falsche Terminologie gewählt wird, ist aus EP-A-0 702 325 bekannt.

Gemäß einem Aspekt der vorliegenden Erfindung wird das Chipmodul somit in einem Schritt zusammen mit dem Verkappen der winzigen integrierten Schaltung hergestellt. Herstellungstechnisch ist also kein weiterer Schritt erforderlich. Hierzu befindet sich die eigentliche integrierte Schaltung vorzugsweise zunächst auf einem Trägerfilm, auf dem sie zur besseren Stabilisierung festgeklebt sein kann. Die Anschlußkontakte der integrierten Schaltung sind über elektrische Verbindungen, vorzugsweise Bonddrähte mit den ebenfalls auf dem Chipträgerelement vorhandenen Anschlußflächen verbunden, wobei die Anschlußflächen später zur eigentlichen Kontaktierung der Chipkarte dienen.

Bei einer derartigen Chipträgerstruktur wird der noch freibleibende eigentliche Chip herkömmlicherweise anschließend mit einer Kunststoffmasse verkappt. Die Verkappung erfolgt standardgemäß entweder mittels eines Harztropfens oder mittels eines Spritzgußprozesses. Anschließend entsteht eine Struktur, bei der auf dem Trägerfilm eine Plastikkapsel vorhanden ist, in der der eigentliche Chip eingeschlossen ist.

Ausgehend von diesem bekannten Stand der Technik setzt der erwähnte erfindungsgemäße Aspekt ein. Statt im wesentlichen nur den Chip und seine Anschlußdrähte zu verkappen, ist gemäß einem Aspekt der vorliegenden Erfindung vorgesehen, den gesamten Chipträger zu verkappen, oder mit anderen Worten, ihn in ein Chipmodul zu gießen oder zu spritzen. Die Form des auf diese Weise erhaltenen Chipmoduls ist vorzugsweise so beschaffen, daß die Stärke des Moduls der einer Standardchipkarte entspricht, so daß der Modul in einen Durchbruch in einer Standardchipkarte eingeschoben oder eingedrückt werden kann. Der bei dieser Lösung einzig freibleibende und somit nicht verkappte Bereich des ursprünglichen Chipträgers stellen die Anschlußflächen dar, da diese zum Kontaktieren der Chipkarte freibleiben müssen.

Gemäß einer bevorzugten Ausgestaltung der vorliegenden Erfindung ist vorgesehen, den Durchbruch am Rande des Kartenkörpers vorzusehen und diesen sowie das Chipmodul so auszugestalten, daß das Chipmodul über den Randbereich in den Kartenkörper eingeschoben werden kann. Dies kann so ausgeführt sein, daß das Chipmodul rein mechanisch in der Chipkarte gehalten wird, wobei dann vorzugsweise außerdem eine mechanische Sicherungseinrichtung vorgesehen ist, die beispielsweise aus Vorsprüngen bestehen kann, die das eingesetzte Chipmodul im eingesetzten Zustand umklammern. Da sich die Erfindung, wie ausgeführt, nicht vordergründig auf die Möglichkeit bezieht, das Chipmodul wechseln zu können, kann das Chipmodul für solche Anwendungen zusätzlich mit dem Kartenkörper verklebt sein.

Gemäß einem weiteren Aspekt kann statt eines Trägerfilms ein Leadframe, d.h. eine Metallbandstruktur verwendet werden, auf der der Chip plaziert wird und über Bonddrähte mit ausgebildeten Anschlußflächen des Leadframes verbunden wird. Das erfindungsgemäße Standardmodul wird dann um diese Struktur herum mittels Gießen oder Spritzen erstellt. Bei dieser Variante entfällt also der oben erwähnte Trägerfilm. Der Schritt des Verkappens des Chips und die Erstellung der standartisierten Außenform fällt aber wiederum zusammen.

Gemäß einem weiteren Aspekt der vorliegenden Erfindung wird ein Verfahren angegeben, mit dem eine derartige Chipkarte einfach hergestellt werden kann. Bei dem angegebenen Verfahren wird das standardisierte erfindungsgemäße Chipmodul mittels eines darauf zugeschnittenen Spritzgußwerkzeuges umspritzt, so daß um das Chipmodul herum der Kartenkörper entsteht. Das Chipmodul ist wiederum ein Gußkörper, der eine Dicke aufweist, die der des herzustellenden Kartenkörpers entspricht. Nach der Herstellung fluchten somit die Hauptoberflächen des Chipmoduls mit der Vorder- und Rückseite des hergestellten Kartenkörpers.

Im folgenden werden bevorzugte Ausgestaltungen der vorliegenden Erfindung unter Bezugnahme auf die beiliegenden Zeichnungen näher erläutert. Dabei zeigen die Zeichnungen im einzelnen:
Fig. 1 eine schematische Ansicht einer bevorzugten Ausführungsform der erfindungsgemäßen Chipkarte;
Fig. 2 eine bevorzugte Ausführungsform für das erfindungsgemäße Chipmodul; und
die Fig. 3 und 4 Querschnittsansichten durch zwei unterschiedliche Varianten bezüglich der Lage des Chips in dem erfindungsgmäßen Chipmodul.

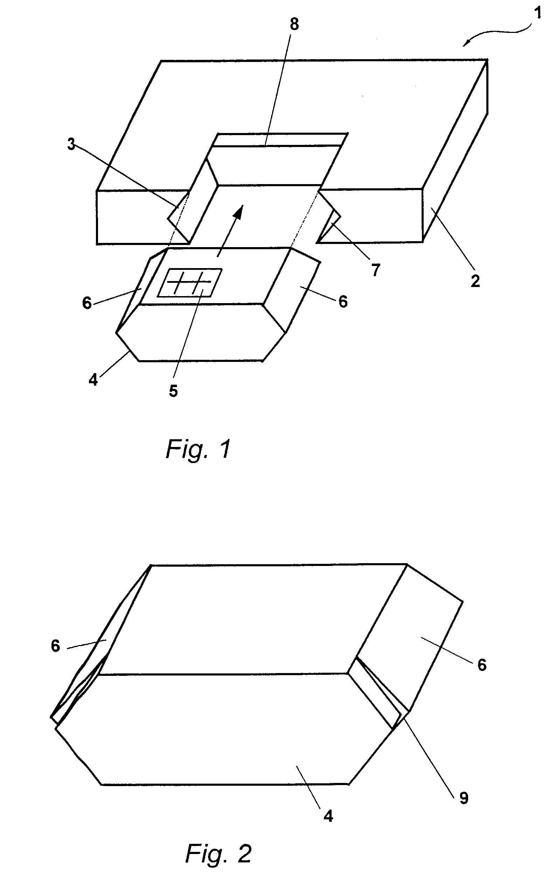

Fig. 1 zeigt eine bevorzugte Ausführungsform der erfindungsgemäßen Chipkarte. Die Chipkarte 1 besteht dabei aus einem Kartenkörper 2 aus Plastik, der einen Durchbruch 3 zur Aufnahme eines standardisierten Chipmoduls 4 aufweist. Das Chipmodul 4 weist eine Dicke auf, die der des Kartenkörpers entspricht und weist somit vorzugsweise eine Dicke von 0,76 mm auf, was der genormten Kartendicke entspricht. Das Chipmodul 4 weist auf seiner Oberfläche Anschlußfelder 5 auf, über die eine Kontaktierung des im Inneren des Moduls 4 befindlichen Chips ermöglicht wird. Das Chipmodul 4 besteht aus einem vorzugsweise Duroplast bestehenden Gußkörper, in den der nicht dargestellte Chip sowie ein die Kontaktfelder tragendes Trägerelement eingegossen ist. Die entsprechenden Elemente können jedoch auch umspritzt werden, so daß das Chipmodul mittels Spritztechnik erstellt wird. Die Abmessungen des Chipmoduls 4 sind dabei derart gewählt, daß selbst sehr große Chips noch einfach darin integriert werden können, so daß unabhängig von der tatsächlichen Chipgröße stets standardisierte Außenabmessungen vorliegen.

Wie erwähnt, übernimmt die Masse die das Trägerelement und den Chip anschließend umgibt und durch die die standardisierte Außenform des Moduls festgelegt wird, auch die Aufgabe, den Chip zu schützen. Eine eigene Verkapselung des Chips mittels Gießharztropfen oder Gußkörper ist daher nicht mehr notwendig.

Die Aussparung 3 in dem Kartenkörper 2 befindet sich vorzugsweise am Rand der Karte. Dadurch kann eine Lösung verwirklicht werden, bei der das Chipmodul 4 in die Karte einschiebbar ist und dort mechanisch und/oder mittels einer Klebeschicht gehalten wird. Zur mechanischen Halterung ist vorzugsweise vorgesehen, daß zwei gegenüberliegende seitliche Ränder 6 des Chipmoduls ein V-förmiges Profil aufweisen, das seine komplementäre Ergänzung in zwei in den Kartenkörper eingearbeiteten Nuten 4 findet. Aufgrund des Ineinandergreifens der V-förmigen Profile mit den Nuten ist ein mechanischer Halt gewährleistet. Ergänzend kann eine Klebeschicht 8 vorzugsweise an der Rückseite des Durchbruchs vorgesehen sein, die erst nach dem vollständigen Einschieben des Chipmoduls in den Kartenkörper mit diesem in Berührung kommt.

Ersichtlicherweise fluchten die Hauptoberflächen des Chipmoduls nach dem Einsetzen in den Kartenkörper mit dessen Oberflächen, da Chipmodul und Kartenkörper die gleiche Dicke aufweisen.

Selbstverständlich kann der Durchbruch 3 im Inneren des Kartenkörpers ausgebildet sein, so daß der Chipmodul 4 mittels Druck in den Kartenkörper gedrückt werden muß und nicht, wie in Fig. 1 gezeigt, mittels einer Schiebebewegung.

Eine V-förmige Profilausbildung ist selbstverständlich nicht zwingend, obwohl vorteilhaft. Die standardisierte Außenform des Moduls sollte lediglich so beschaffen sein, daß eine leichte "Verankerung" im Kartenkörper ermöglicht wird.

Damit das Chipmodul 4 nach dem Einschieben in den Kartenkörper 2 sicher gehalten wird, kann, wie in Fig. 2 gezeigt, das seitliche V-förmige Profil 6 so ausgebildet sein, daß an dem der Einschubrichtung gegenüberliegenden Ende des Profils ein Vorsprung 9 ausgebildet ist, der nach dem Einschieben des Moduls 4 in den Kartenkörper 2 in in die Nuten 4 des Kartenkörpers 2 eingearbeite (nicht einzeln dargestellte) Vorsprünge eingreift. Somit "verhakt" sich das Modul, nachdem es vollständig in den Kartenkörper 2 eingeschoben wurde, mit dem Kartenkörper und wird dadurch sicher in diesem gehalten. Wie in Fig. 2 dargestellt, kann der Vorsprung 9 dadurch gebildet sein, daß sich das V-förmige Profil zum Ende des Moduls hin verbreitert, so daß das Einschieben mit zunehmender Einschiebetiefe erschwert wird und in der endgültigen Position ein Eingreifen der in den Nuten 4 des Kartenkörpers 2 vorgesehenen Vorsprünge gegen die im Profil des Moduls ausgebildete Kante 9 erfolgt.

Durch entsprechendes Biegen des Kartenkörpers ist es auch möglich, das eingesetzte Chipmodul wieder aus dem Kartenkörper zu entfernen. Vorzugsweise läßt sich das Chipmodul mittels einer entsprechenden Verriegelungseinrichtung in den Kartenkörper "einschnappen" und anschließend auch wieder entfernen.

Die erfindungsgemäße Standardisierung des Chipmoduls 4 erweist sich auch bei der Herstellung des Kartenkörpers 2 als vorteilhaft.

Vorzugsweise wird der Kartenkörper mittels eines Spritzgußverfahrens hergestellt, und zwar derart, daß um das bereitgestellte Chipmodul herum gespritzt wird. Da das Chipmodul, wie erwähnt, in seinen Abmessungen standardisiert ist, muß der Hersteller des Kartenkörpers 2 nur ein einziges daraufhin abgestimmtes Spritzgußwerkzeug vorsehen. Das verwendete Werkzeug kann somit auf die Standardgröße hin zugeschnitten sein und muß selbst bei Verwendung anderer Chiparten nicht verändert werden, da sich die Abmessungen des Moduls 4 selbst trotz siche ändernder Chipgrößen nicht verändern.

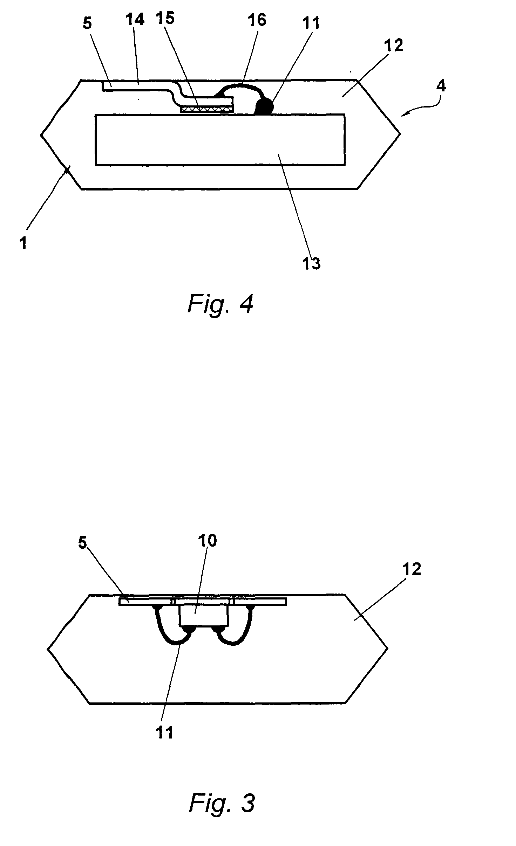

Die Fig. 3 und 4 zeigen Querschnitte durch ein Chipmodul 4 zur Verdeutlichung zweier unterschiedlicher Varianten, wie der im Chipmodul 4 eingebettete Chip darin plaziert sein kann. Fig. 3 zeigt zunächst eine Anordnung des Chips 10, die einer herkömmlichen Anordnung eines Chips in einem Modul entspricht. Der Chip 10 weist mit seiner die Kontaktstellen tragenden aktiven Schicht in das Innere des Moduls. Eine Verbindung zwischen den äußeren Kontaktfeldern 5 mit den Anschlußkontakten des Chips erfolgt über Bondverbindungen 11. Der Chip 10 und die Kontaktfelder 5, die auf einem Trägerfilm aufgebracht sein können, sind mittels einer Gußmasse 12 vergossen, wodurch insgesamt das Chipmodul 4 entsteht. Ein geeignetes Herstellungverfahren zum Vergießen des Chips durch die Gußmasse 12 ist beispielsweise in den deutschen Patentanmeldungen P 44 44 812 und P 44 01 588 beschrieben.

In der Variante gemäß Fig. 4 ist der Chip 13 mit seiner die Kontaktstellen tragenden aktiven Seite zu den Anschlußfeldern 5 hin ausgerichtet. Die Anschlußfelder 5 werden dabei von einem Kontaktstrang gebildet, der, wie aus Fig. 4 ersichtlich ist, zur Oberfläche des Chips 13 in das Innere des Moduls hinein verläuft. Der Kontaktstrang 14 ist über eine isolierende Schicht 15 mit dem Chip 13 verbunden. Die Kontaktierung der Kontaktstellen des Chips mit dem Kontaktstrang 14, über den wiederum eine Verbindung mit den Kontaktfeldern 5 ermöglicht wird, erfolgt mittels Bondverbindungen 16. Die Variante gemäß Fig. 4 ist insbesondere bei Verwendung sehr großer Chips 13 vorteilhaft, da durch die Anordnung des Kontaktstrangs 14, der vorzugsweise mit einer sogenannten Lead-on-Chip-Verbindung verwirklicht wird, auf einer Seite des Chips gemeinsam mit den Bondverbindungen 16, eine geringere Gesamthöhe entsteht als im Falle, daß die Bondverbindungen auf der anderen Seite des Chips ausgebildet sind. Mit dieser Technik können also Chipgrößen untergebracht werden, die eine Dicke aufweisen, die nur geringfügig unterhalb der ermittelten Kartendicke liegt.

Es wurde bereits angedeutet, daß statt des Durchbruches im Kartenkörper auch lediglich eine Aussparung im Kartenkörper vorgesehen sein kann. Diese Variante weist insbesondere für das Bedrucken der Rückseite der Karte Vorteile auf. Bei den bisherigen Modulen, die nicht in ein standardisiertes Außenproil vergossen oder verspritzt werden, entstanden im Inneren der Karte zwischen Modul und Kartenkörper Hohlräume, die ein Nachgeben der Rückseite während des Bedruckens bewirkten. Da gemäß der vorliegenden Erfindung der Chipmodul eine Außenform aufweist, die einen lückenlosen Übergang vom Modul zum Kartenkörper ermöglicht, entstehen keine "weichen Stellen", die während des Bedruckens Schwierigkeiten bereiten. Wird eine Aussparung im Kartenkörper statt eines Durchbruches verwendet, so können dennoch alle oben genannten besonderen Ausgestaltungen weiterhin verwirklicht werden.

## Patentansprüche

1. Chipkarte, bestehend aus einem standardisierten Kartenkörper (2) mit einem standardisierten Durchbruch (3) zur Aufnahme eines einen Chip enthaltenden sowie entsprechende von außen zugängliche Anschlußfelder (5) tragenden gegossenen oder gespritzen Chipmoduls (4), wobei das Modul ebenfalls derart standardisiert gefertigt ist, daß es paßgenau in den Durchbruch des Kartenkörpers einsetzbar ist und seine beiden parallelen Oberflächen jeweils mit der Vorder- und Rückseite des Kartenkörpers fluchten.

2. Chipkarte nach Anspruch 1, **dadurch gekennzeichnet**, daß das Modul nach dem Einsetzen in den Kartenkörper mechanisch in diesem gehalten wird.

3. Chipkarte nach Anspruch 2, **dadurch gekennzeichnet**, daß das Chipmodul als geschlossener Körper ausgeführt ist und ein Verankerungsprofil aufweist, das in Zusammenwirkung mit einem komplementären Profil im Kartenkörper den mechanischen Halt gewährleistet.

4. Chipkarte nach Anspruch 2 oder 3, **dadurch gekennzeichnet**, daß das Chipmodul mittels einer Veriegelungseinrichtung, vorzugsweise einem Schnappverschluß, im Kartenkörper gehalten wird.

5. Chipkarte nach Anspruch 2, 3 oder 4, **dadurch gekennzeichnet**, daß das Modul zusätzlich mit dem Kartenkörper verklebt ist.

6. Chipkarte nach Anspruch 2, 3, 4 oder 5, **dadurch gekennzeichnet**, daß das Modul an mindestens zwei gegenüberliegenden Seiten ein V-förmiges Profil (6) aufweist und die Aussparung des Kartenkörpers an entsprechend gegenüberliegenden Seiten komplementäre Nuten (4) aufweist, derart, daß nach dem Einsetzen des Moduls in den Kartenkörper aufgrund des Ineinandergreifens des V-förmigen Modulprofils in die im Kartenkörper ausgebildeten Nuten ein sicherer Halt des Moduls im Durchbruch des Kartenkörpers gewährleistet ist.

7. Chipkarte nach Anspruch 6**, dadurch gekennzeichnet**, daß der Duchbruch am Kartenkörperrand ausgebildet ist, derart, daß das Modul über eine offene Seite des Kartenkörpers in den Durchbruch eingeschoben werden kann.

8. Chipkarte nach Anspruch 7, **dadurch gekennzeichnet**, daß das an gegenüberliegenden Seiten des Moduls ausgebildete V-förmige Profil zu der zur Einschubrichtung gegenüberliegenden Seite hin einen Vorsprung (9) ausbildet, derart, daß sich das Modul nach dem Einschieben mittels des Vorsprungs gegen einen entsprechenden, in den Nuten des Kartenkörpers ausgebildeten Vorsprung abstützt, wodurch eine Sicherung des Moduls im Durchbruch des Kartenkörpers erreicht wird.

9. Chipkarte nach einem der vorhergehenden Ansprüche, **dadurch gekennzeichnet**, daß der Chip innerhalb des Moduls so ausgerichtet ist, daß die Anschlußkontakte des Chips zu den von außen zugänglichen Anschlußfeldern (5) des Moduls hin ausgerichtet sind.

10. Chipkarte nach Anspruch 9, **dadurch gekennzeichnet**, daß die von außen zugänglichen Anschlußfelder (5) des Moduls von einem Leiterstrang (14) gebildet werden, der in das Innere des Moduls zum Chip (13) hin verläuft und über eine isolierende Zwischenschicht (15) mit der aktiven Seite des Chips verbunden ist und eine Verbindung zwischen den Anschlußkontakten des Chips (13) und dem Leiterstrang (14) mittels Bondverbindungen (16) hergestellt ist.

11. Verfahren zum Herstellen einer Chipkarte mit folgenden Schritten:
Bereitstellen eines einen Chip enthaltenden sowie entsprechende Anschlußfelder (5) tragenden gegossenen und in seinen Abmessungen standardisierten Chipmoduls, wobei der Chipmodul eine Dicke aufweist, die der Dicke der herzustellenden Chipkarte entspricht,
Verwenden eines auf die standardisierten Abmessungen des Chipmoduls angepaßten Spitzgußwerkzeugs, und
Umspritzen des Moduls mittels des Spritzgußwerkzeuges mit Spritzgußmasse zum Erzeugen eines Chipkartenkörpers, der das Modul umgibt, wobei die Vorderseite des erzeugten Chipkartenkörpers mit der Oberfläche des Chipmoduls, auf der die von außen zugänglichen Anschlußfelder ausgebildet sind, und die Rückseite des hergestellten Chipkartenkörpers mit der entsprechenden Rückseite des Chipmoduls fluchtet.

12. Chipkarte, bestehend aus einem standardisierten Kartenkörper mit einer standardisierten Aussparung zur Aufnahme eines einen Chip enthaltenden sowie entsprechende von außen zugängliche Anschlußfelder tragenden Chipmoduls, wobei das Chipmodul als geschlossener, vorzugsweise quaderförmiger Block gefertigt ist, der paßgenau in die Aussparung einsetzbar ist und dessen die Anschlußfelder tragende Oberfläche nach dem Einsetzen in den Kartenkörper mit der entsprechenden Oberfläche des Kartenkörpers fluchtet.

13. Chipkarte nach Anspruch 12, **dadurch gekennzeichnet**, daß das Modul nach dem Einsetzen in den Kartenkörper mechanisch in diesem gehalten wird.

14. Chipkarte nach Anspruch 13, **dadurch gekennzeichnet**, daß das Chipmodul als geschlossener Körper ausgeführt ist und ein Verankerungsprofil aufweist, das in Zusammenwirkung mit einem komplementären Profil im Kartenkörper den mechanischen Halt gewährleistet.

15. Chipkarte nach Anspruch 14, **dadurch gekennzeichnet**, daß das Chipmodul mittels einer Verriegelungseinrichtung, vorzugsweise einem Schnappverschluß, im Kartenkörper gehalten wird.

16. Chipkarte nach Anspruch 15, **dadurch gekennzeichnet**, daß das Modul zusätzlich mit dem Kartenkörper verklebt ist.

17. Chipkarte nach einem der vorhergehenden Ansprüche, **dadurch gekennzeichnet**, daß der Chip innerhalb des Moduls so ausgerichtet ist, daß die Anschlußkontakte des Chips zu den von außen zugänglichen Anschlußfeldern (5) des Moduls hin ausgerichtet sind.

18. Chipkarte nach Anspruch 17, **dadurch gekennzeichnet**, daß die von außen zugänglichen Anschlußfelder (5) des Moduls von einem Leiterstrang (14) gebildet werden, der in das Innere des Moduls zum Chip (13) hin verläuft und über eine isolierende Zwischenschicht (15) mit der aktiven Seite des Chips verbunden ist und eine Verbindung zwischen den Anschlußkontakten des Chips (13) und dem Leiterstrang (14) mittels Bondverbindungen (16) hergestellt ist.

19. Verfahren zum Herstellen eines Chipmoduls mit folgenden Schritten:
Bereitstellen eines Trägerelementes enthaltend eine integrierte Schaltung, die über elektrische Verbindungen, vorzugsweise Bonddrähte mit Anschlußkontakten des Trägerelementes verbunden ist, jedoch noch nicht von einer als Verkappung dienenden Kunststoffmasse ummantelt ist,
Erstellen eines Chipmoduls aus dem Chipträgerelement mittels Gieß- oder Spritztechnik, indem nicht nur die integrierte Schaltung sondern das gesamte Chipträgerelement mittels einer Kunststoffmasse ummantelt wird, mit Ausnahme der Anschlußfelder, und in eine Form gebracht wird, die das Chipmodul geeignet macht, in einen, einen entsprechenden Durchbruch aufweisenden Standardchipkartenkörper eingesetzt zu werden.
